# EUROPÄISCHE PATENTSCHRIFT

(11) **EP 1 926 359 B1**
(45) Veröffentlichungstag und Bekanntmachung des Hinweises auf die Patenterteilung: **31.10.2012**
(21) Anmeldenummer: 07022157.7
(22) Anmeldetag: 15.11.2007
(51) Int. Cl.: H05K 5/02, H05K 5/06

(54) **Elektrogehäuse**
Casing for an electric device
Boîtier électrique

(30) Priorität: 24.11.2006 DE 202006018028 U
(43) Veröffentlichungstag der Anmeldung: 28.05.2008
(73) Patentinhaber: Kraft, Thomas, 53842 Troisdorf (DE)
(72) Erfinder: Kraft, Thomas, 53842 Troisdorf (DE)
(74) Vertreter: Müller-Gerbes Wagner Albiger Patentanwälte

(56) Entgegenhaltungen:
- DE-A1- 19 837 379
- DE-C1- 4 302 835
- US-A- 6 057 779
- US-A1- 2002 060 086
- US-A1- 2006 089 034

## Beschreibung

Die Erfindung betrifft ein Elektrogehäuse, insbesondere zur gegenüber der Gehäuseumgebung abgedichteten Aufnahme und Aufbewahrung von elektrischen und elektronischen Komponenten, bestehend aus einem Korpus und einem am Korpus festlegbaren Verschlusselement, wobei der Korpus eine vom Verschlusselement verschließbare Gehäuseöffnung aufweist und wobei die beiden Gehäuseteile gegen das Eindringen von Fremdkörpern und Feuchtigkeit abdichtbar und zumindest nahezu spaltfrei aneinander positionierbar sind.

Derartige "spaltfreie" Gehäuse sind beispielsweise aus der DE-U 297 05 468 bekannt, bei der die Spaltfreiheit des Elektrogehäuses durch ein in besonderer Art und Weise ausgebildetes Scharnier hergestellt wird, bei dem das korpusseitige Scharnierteil federnd am Korpus befestigt und gegen die Rückstellkraft der federnden Befestigung translatorisch beweglich ist, so dass das Türblatt unmittelbar, also spaltfrei am Korpus anliegen kann.

Derartige spaltfreie Elektrogehäuse haben sich insbesondere deshalb bewährt, da sie als vandalismussicher gelten, indem kein Werkzeug zwischen Korpus und Verschlusselement mit dem Ziel angesetzt werden kann, das Verschlusselement gewaltsam durch Aufbrechen oder Aufbiegen zu öffnen. Die Gehäuse müssen dabei nicht nur vandalismussicher sein, sondern auch eine äußerst hohe Dichtigkeit aufweisen, um zum einen das Gehäuseinnere gegenüber Verunreinigung zu schützen und zum anderen das Gehäuse - beispielsweise für den Einsatz in Reinräumen - in bestmöglichem Maße reinigen zu können, wozu beispielsweise Hochdruckreiniger verwendet werden. Hierfür sind die Gehäuse üblicherweise aus Edelstahlblechen ausgeführt und müssen gegen das Eindringen von gefährlichen Teilchen, festen Fremdkörpern und Feuchtigkeit einen hohen Schutzwiderstand aufweisen. Diese Prüfkriterien sind in DIN VDE 0470, Teil 1, 11.92 Schutzarten für Gehäuse (IP-Code), EN 60529-1991 und DIN 400 50, Teil 9-05.93 festgelegt. Als Schutzart für solche vandalismussichere hochdichte Elektrogehäuse wird IP 69 K angestrebt.

Andere Gehäuse sind aus US 2002/0060086, DE 198 37 379 und DE 43 02 835 bekannt.

Es liegt der vorliegenden Erfindung die Aufgabe zugrunde, ein spaltfreies Elektrogehäuse zur Verfügung zu stellen, das eine verbesserte Reinigungsfreundlichkeit aufweist und insbesondere der Schutzart IP 69 K zuzurechnen ist.

Diese Aufgabe wird erfindungsgemäß durch ein Elektrogehäuse nach Anspruch 1 gelöst. Das Verschlusselement ist auf seinen der Umgebung des Gehäuses zugewandten Außenseiten beschlagfrei ausgebildet . Hierdurch ergibt sich der wesentliche Vorteil, dass die Außenseiten des Verschlusselements vollständig geschlossene Oberflächen aufweisen, die extrem reinigungsfreundlich sind und keine Ansammlung von Verunreinigungen ermöglichen. In diesem Zusammenhang ist es von besonderem Vorteil, wenn die der Umgebung des Gehäuses zugewandten Außenseiten des Verschlusselements frei von Absätzen, Vorsprüngen und Rücksprüngen ausgeführt sind und nur in etwa rechtwinklige positive Kanten aufweisen. Demnach weist also das Verschlusselement insbesondere eine großflächige Vorderseite und umlaufende Seitenränder auf, die im Winkel von etwa 90° zur Vorderseite nach hinten in Richtung auf den Korpus abgebogen sind und mit ihrem freien Ende spaltfrei am Korpus anliegen.

Soweit im Rahmen der vorliegenden Unterlagen von "spaltfrei" die Rede ist, so sei hierunter ein zumindest mittelbares flächiges Anliegen des Verschlusselements am Korpus zu verstehen, wodurch allenfalls ein Spalt im Mikrometerbereich verbleibt, der aber weder in wesentlichem Maße Verunreinigungen noch Feuchtigkeit, Spritzwasser oder elektromagnetische Strahlung durchlässt.

Besonders wesentlich für die vorliegende Erfindung ist es, daß das Elektrogehäuse eine Schließvorrichtung aufweist, die auf den Korpus und das Verschlusselement einwirkt, die von den der Umgebung des Gehäuses zugewandten Außenseiten des Verschlusselements gegenüber der Umgebung verdeckt ist und die fernbetätigbar ist. Erst durch eine solche fernbetätigbare Schließvorrichtung ist es möglich, das Verschlusselement vollständig auf seiner der Umgebung zugewandten Außenseite beschlagfrei auszuführen und damit Kanten, Ecken und Vertiefungen zu vermeiden, die zur Ansammlung von Verunreinigungen führen würden.

Die Fernbetätigung der Schließvorrichtung kann entweder drahtlos, insbesondere über eine Funkfernbedienung und/oder einen Transponder erfolgen; ebenso ist es aber auch möglich, die Schließvorrichtung über einen externen Schalt-/Betätigungsmechanismus zu aktivieren, der insbesondere über ein Netzwerk an die Schließvorrichtung angekoppelt ist. Zweckmäßigerweise sollte auch die Fernbetätigung so ausgebildet sein, dass sie keine eigene Verunreinigungsquelle darstellt, so dass die Fernbetätigung entweder nicht stationär im verunreinigungskritischen Nahbereich des Gehäuses angeordnet wird oder aber ohnehin nur mit Komponenten arbeitet, die im Gehäuseinneren angeordnet sind.

Besonders vorteilhaft an einer solchen fernbetätigbaren Schließvorrichtung ist die Möglichkeit, die Schließvorrichtung mit einer Vorrichtung zur Berechtigungsprüfung zu versehen, so dass die Vandalismussicherheit auch in dieser Hinsicht noch weiter verbessert wird. Hierbei können beispielsweise bei Einsatz einer Funksteuerung digital kodierbare Sender und Empfänger vorgesehen werden, um eine dezentrale Ansteuerung des Verschlussmechanismus zu realisieren. In ähnlicher Weise können eine Codekarte (Sender) und ein Kartenleser durch berührungslosen (Funk-)Datenaustausch zusammenwirken, wobei dann der Kartenleser zweckmäßigerweise in der Nähe des Elektrogehäuses angeordnet ist. Und schließlich kann die Berechtigungsprüfung dadurch erfolgen, dass die Schließvorrichtung über eine zentrale Warte/Steuerungszentrale angesteuert wird über beispielsweise ein Netzwerk, wobei dann die Berechtigungsprüfung zusammen mit der Steuerungszentrale erfolgen kann.

Die Betätigung der Schließvorrichtung, also das Öffnen und Schließen kann sowohl magnetisch als auch elektrisch und/oder elektromechanisch erfolgen, indem beispielsweise ein Elektromagnet oder ein Stellmotor verwendet wird. Ein weiterer wesentlicher Aspekt der vorliegenden Erfindung besteht darin, wenn das beschlagfreie Elektrogehäuse eine notentriegelbare Schließvorrichtung aufweist, wobei die Notentriegelung beispielsweise elektrisch und insbesondere drahtlos oder mechanisch betätigbar sein kann. So können so genannte "Aufschnapper" verwendet werden, die mit Haustüröffnern vergleichbar sind; beim Anlegen von 9 V-Gleichspannung entriegeln diese Aufschnapper die jeweiligen Befestigungspunkte der Schließvorrichtung, beispielsweise Vorreiber oder Stangenschlösser. Hierzu sind beispielsweise zwei Steueradern an einer geheimen Stelle im Gehäuse anzuordnen, so dass man von außen gegebenenfalls die Gleichspannung anlegen und dadurch die Notentriegelung durchführen kann.

Daneben kann die Notentriegelung aber auch mechanisch durch Aufbohren erfolgen. Hierzu werden an fest definierten Stellen (beispielsweise mittels einer Schablone wiederzufindende) Bohrpunkte definiert. Hinter diesen Bohrpunkten sitzen mechanische Entriegelungspunkte, die mittels eines Spezialschlüssels eine Notentriegelung gewährleisten.

Durch die Notentriegelung ist es möglich, das Elektrogehäuse tatsächlich beschlagfrei auszuführen und dennoch alle notwendigen Funktionen zur Verfügung zu stellen.

Weitere Merkmale und Vorteile der vorliegenden Erfindung ergeben sich aus der nachfolgenden Beschreibung eines Ausführungsbeispiels anhand der Zeichnung; diese zeigt in
- Figur 1: eine perspektivische Ansicht eines erfindungsgemäßen Elektrogehäuses; und
- Figur 2: ein Detail des Elektrogehäuses im Horizontalschnitt.

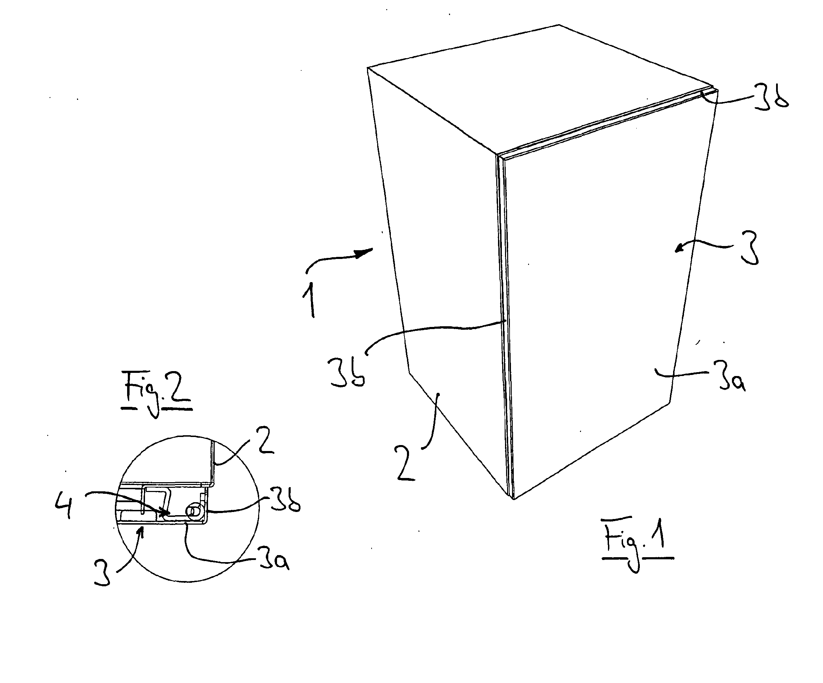

In Figur 1 ist ein Elektrogehäuse 1 dargestellt mit einem quaderförmigen Korpus 2 mit an der Vorderseite vorgesehener Gehäuseöffnung, die durch ein Verschlusselement in Form einer Türe 3 verschlossen werden kann. Die Türe weist eine großflächige Vorderseite 3a und umlaufende Seitenränder 3b auf, die im Winkel von etwa 90° zur Vorderseite nach hinten in Richtung auf den Korpus 2 abgebogen sind und mit ihrem freien Ende spaltfrei am Korpus anliegen, indem auf der Innenseite der Türe 3 angeordnete Scharniere 4 vorgesehen sind, die in an sich bekannter Art und Weise mittels Federvorspannung die in Schließstellung befindliche Türe gegen den Korpus drücken.

Das erfindungsgemäße Gehäuse weist auf seinen der Umgebung zugewandten Außenseiten 3a, 3b der Türe 3 und des Korpus 2 keine Beschläge oder Beschlagbefestigungen auf, da diese auf der Innenseite des Gehäuses bzw. der Türe angeordnet und fernbetätigbar ausgebildet sind.

Insgesamt erhält man durch die vorliegende Erfindung ein Gehäuse nach Schutzart IP 69 K, das höchsten Anforderungen an Vandalismussicherheit und Reinigungsfreundlichkeit entspricht. Hauptverantwortlich hierfür ist ein völlig glattes Verschlusselement, das keine sichtbaren Scharniere, Beschläge und Verschlüsse aufweist, das keine Schmutzablagerungen im Bereich von Unebenheiten bzw. eine optimale Zugänglichkeit für Reinigungsarbeiten begünstigt und das eine höchste Zugangssicherheit zum Gehäuseinneren ermöglicht, da es nur durch gesicherte Entriegelungsmethoden zugänglich ist. Bei Gehäusen nach Schutzart IP 69 K liegt darüber hinaus eine Vandalismussicherheit vor, da keine Beschläge und Verschlüsse vorhanden sind und da durch den spaltfreien Bereich zwischen Korpus und Verschlusselement kein Angriffspunkt für Hebel und sonstige Aufbruchswerkzeuge gegeben ist. Schließlich kann das Gehäuse in einfacher Weise in eine zentrale Überwachung eingebunden werden.

## Patentansprüche

1. Elektrogehäuse, insbesondere zur gegenüber der Gehäuseumgebung abgedichteten Aufnahme und Aufbewahrung von elektrischen und elektronischen Komponenten, bestehend aus einem Korpus (2) und einem am Korpus festlegbaren Verschlusselement (3), wobei der Korpus eine vom Verschlusselement verschließbare Gehäuseöffnung aufweist und wobei die beiden Gehäuseteile gegen das Eindringen von Fremdkörpern und Feuchtigkeit dicht und spaltfrei aneinander positionierbar sind, wobei das Verschlusselement (3) auf seinen der Umgebung des Gehäuses (1) zugewandten Außenseiten (3a, 3b) beschlagfrei ausgebildet ist, **dadurch gekennzeichnet, dass** das Elektrogehäuse (1) eine Schließvorrichtung aufweist, die auf den Korpus (2) und das Verschlusselement (3) einwirkt, die von den der Umgebung des Gehäuses zugewandten Außenseiten (3a, 3b) des Verschlusselements gegenüber der Umgebung verdeckt ist und die fernbetätigbar ist.

2. Elektrogehäuse nach Anspruch 1, **dadurch gekennzeichnet, dass** die Fernbetätigung der Schließvorrichtung drahtlos, insbesondere über eine Funkfernbedienung und/oder einen Transponder erfolgt.

3. Elektrogehäuse nach Anspruch 1, **dadurch gekennzeichnet, dass** die Fernbetätigung der Schließvorrichtung über einen externen Schalt-/Betätigungsmechanismus erfolgt, der insbesondere über ein Netzwerk an die Schließvorrichtung angekoppelt ist.

4. Elektrogehäuse nach einem der Ansprüche 1 bis 3, **dadurch gekennzeichnet, dass** die Schließvorrichtung eine Vorrichtung zur Berechtigungsprüfung aufweist.

5. Elektrogehäuse nach einem der Ansprüche 1 bis 4, **dadurch gekennzeichnet, dass** die Schließvorrichtung magnetisch betätigbar ist.

6. Elektrogehäuse nach einem der Ansprüche 1 bis 4, **dadurch gekennzeichnet, dass** die Schließvorrichtung elektrisch und/oder elektromechanisch betätigbar ist.

7. Elektrogehäuse nach einem der Ansprüche 1 bis 6, **dadurch gekennzeichnet, dass** die Schließvorrichtung notentriegelbar ist.

8. Elektrogehäuse nach Anspruch 7, **dadurch gekennzeichnet, dass** die Notentriegelung elektrisch und insbesondere drahtlos betätigbar ist.

9. Elektrogehäuse nach Anspruch 7 oder 8, **dadurch gekennzeichnet, dass** die Notentriegelung mechanisch betätigbar ist.

10. Elektrogehäuse nach einem der Ansprüche 1 bis 9, **dadurch gekennzeichnet, dass** das Verschlusselement (3) ein Gehäusedeckel oder eine Gehäusetüre ist.

11. Elektrogehäuse nach einem der Ansprüche 1 bis 10, **dadurch gekennzeichnet, dass** das Gehäuse (1) eine Dichtigkeit nach Schutzart IP 69K aufweist.

12. Elektrogehäuse nach einem der Ansprüche 1 bis 11, **dadurch gekennzeichnet, dass** das Verschlusselement (3) über auf seiner dem Gehäuse zugewandten Innenseite angeordnete Scharniere (4) am Korpus (2) festgelegt ist.

13. Elektrogehäuse nach einem der Ansprüche 1 bis 12, **dadurch gekennzeichnet, dass** die der Umgebung des Gehäuses (1) zugewandten Außenseiten (3a, 3b) des Verschlusselements (3) frei von Absätzen, Vorsprüngen und Rücksprüngen ausgeführt sind und nur in etwa rechtwinklige positive Kanten aufweisen.

## Claims

1. Electrical device housing, in particular for the sealed receiving and storage of electrical and electronic components relative to the surroundings of the housing, consisting of a body (2) and a closure element (3), which can be fixed to the body, the body having a housing opening that can be closed by the closure element and it being possible to position the two housing parts against one another sealed against the penetration of extraneous bodies and moisture and without a gap, the closure element (3) being free of fittings on its outer sides (3a, 3b) facing the surroundings of the housing (1), **characterised in that** the electrical device housing (1) has a closing device, which acts on the body (2) and the closure element (3) and which is concealed relative to the surroundings by the outer sides (3a, 3b) of the closure element facing the surroundings of the housing and can be remotely actuated.

2. Electrical device housing according to claim 1, **characterised in that** the remote actuation of the closing device takes place wirelessly, in particular by radio remote control and/or a transponder.

3. Electrical device housing according to claim 1, **characterised in that** the remote actuation of the closing device takes place by means of an external switching/actuating mechanism, which is, in particular, coupled via a network to the closing device.

4. Electrical device housing according to any one of claims 1 to 3, **characterised in that** the closing device has a device for checking authorisation.

5. Electrical device housing according to any one of claims 1 to 4, **characterised in that** the closing device can be actuated magnetically.

6. Electrical device housing according to any one of claims 1 to 4, **characterised in that** the closing device can be actuated electrically and/or electromechanically.

7. Electrical device housing according to any one of claims 1 to 6, **characterised in that** the closing device is unlockable in an emergency.

8. Electrical device housing according to claim 7, **characterised in that** the emergency unlocking mechanism can be actuated electrically and, in particular, wirelessly.

9. Electrical device housing according to claims 7 or 8, **characterised in that** the emergency unlocking mechanism can be actuated mechanically.

10. Electrical device housing according to any one of claims 1 to 9, **characterised in that** the closure element (3) is a housing lid or a housing door.

11. Electrical device housing according to any one of claims 1 to 10, **characterised in that** the housing (1) has a tightness according to protection rating IP69K.

12. Electrical device housing according to any one of claims 1 to 11, **characterised in that** the closure element (3) is fixed to the body (2) by hinges (4) arranged on its inner side facing the housing.

13. Electrical device housing according to any one of claims 1 to 12, **characterised in that** the outer sides (3a, 3b) of the closure element (3) facing the surroundings of the housing (1) are free of steps, projections and recesses and only have approximately right angled positive edges.

## Revendications

1. Boîtier électrique, en particulier pour recevoir et conserver des composants électriques et électroniques de manière étanche par rapport à l'environnement du boîtier, composé d'un corps (2) et d'un élément de fermeture (3) pouvant être fixé au corps, dans lequel ledit corps présente une ouverture de boîtier pouvant être fermée par l'élément de fermeture, et dans lequel les deux parties de boîtier peuvent être positionnées l'une contre l'autre de manière étanche et sans intervalle afin d'éviter la pénétration de corps étrangers et d'humidité, dans lequel l'élément de fermeture (3) est réalisé sans ferrures sur ses faces extérieures (3a, 3b) tournées vers l'environnement du boîtier (1), **caractérisé en ce que** le boîtier électrique (1) présente un dispositif de fermeture agissant sur le corps (2) et l'élément de fermeture (3) et qui est masqué par les faces extérieures (3a, 3b) de l'élément de fermeture, tournées vers l'environnement du boîtier, et qui peut être télécommandé.

2. Boîtier électrique selon la revendication 1, **caractérisé en ce que** la télécommande du dispositif de fermeture est effectuée sans fil, en particulier par l'intermédiaire d'une radio télécommande et/ou d'un transpondeur.

3. Boîtier électrique selon la revendication 1, **caractérisé en ce que** la télécommande du dispositif de fermeture s'effectue par l'intermédiaire d'un mécanisme de
commutation/commande externe qui est en particulier couplé avec le dispositif de fermeture par l'intermédiaire d'un réseau.

4. Boîtier électrique selon l'une quelconque des revendications 1 à 3, **caractérisé en ce que** le dispositif de fermeture présente un dispositif de contrôle d'autorisation.

5. Boîtier électrique selon l'une quelconque des revendications 1 à 4, **caractérisé en ce que** le dispositif de fermeture peut être à commande magnétique.

6. Boîtier électrique selon l'une quelconque des revendications 1 à 4, **caractérisé en ce que** le dispositif de fermeture peut être à commande électrique et/ou électromécanique.

7. Boîtier électrique selon l'une quelconque des revendications 1 à 6, **caractérisé en ce que** le dispositif de fermeture dispose d'un déverrouillage de secours.

8. Boîtier électrique selon la revendication 7, **caractérisé en ce que** le déverrouillage de secours peut être à commande électrique et en particulier sans fil.

9. Boîtier électrique selon la revendication 7 ou 8, **caractérisé en ce que** le déverrouillage de secours peut être à commande mécanique.

10. Boîtier électrique selon l'une quelconque des revendications 1 à 9, **caractérisé en ce que** l'élément de fermeture (3) est un couvercle de boîtier ou une porte de boîtier.

11. Boîtier électrique selon l'une quelconque des revendications 1 à 10, **caractérisé en ce que** le boîtier (1) présente une étanchéité selon le type de protection IP 69K.

12. Boîtier électrique selon l'une quelconque des revendications 1 à 11, **caractérisé en ce que** l'élément de fermeture (3) est fixé au corps (2) par des charnières (4) disposées sur sa face intérieure tournée vers le boîtier.

13. Boîtier électrique selon l'une quelconque des revendications 1 à 12, **caractérisé en ce que** les faces extérieures (3a, 3b) de l'élément de fermeture (3), tournées vers l'environnement du boîtier (1), sont réalisées sans saillies ni retraits et présentent seulement des arêtes positives approximativement à angle droit.
